# EUROPEAN PATENT SPECIFICATION

(11) **EP 3 896 399 B1**
(45) Date of publication and mention of the grant of the patent: **09.11.2022**
(21) Application number: 20169626.7
(22) Date of filing: 15.04.2020
(51) Int. Cl.: G01D 5/20

(54) **SENSOR DEVICE AND SENSOR ASSEMBLY FOR MEASURING THE ROTATIONAL POSITION OF AN ELEMENT**
SENSORVORRICHTUNG UND SENSORANORDNUNG ZUR MESSUNG DER DREHPOSITION EINES ELEMENTS
DISPOSITIF DE CAPTEUR ET ENSEMBLE CAPTEUR POUR MESURER LA POSITION D'UN ÉLÉMENT EN ROTATION

(43) Date of publication of application: 20.10.2021
(73) Proprietor: TE Connectivity Belgium BVBA, 8020 Oostkamp (BE); TE Connectivity Germany GmbH, 64625 Bensheim (DE)
(72) Inventor: OCKET, Tom, 8820 Torhout (BE); BECKER, Tobias, 68789 St. Leon-Rot (DE); HARZ, Moritz, 67346 Speyer (DE)
(74) Representative: Grünecker Patent- und Rechtsanwälte PartG mbB

(56) References cited:
- WO-A1-2017/100515
- DE-A1-102017 222 575
- US-A1- 2008 164 869
- US-A1- 2012 293 166
- US-A1- 2019 056 244

## Description

The invention relates to a sensor device and a sensor assembly for measuring the rotational position of an encoder member that is rotatable about an axis of rotation.

Such sensor devices often comprise at least one sender member for emitting a magnetic field and a plurality of receiving members for receiving the magnetic field.

According to an example, the encoder member is made of a conductive material, having a shape with a periodic structure in a circumferential direction. The receiving member comprises an inductive component. Thus, the rotational position of the encoder member can be determined.

According to an alternative example, a sender member is arranged at the stator. The receiving members are arranged at the stator to sense the magnetic field generated by the sender member. In more detail, a conductor forms each receiving member. Each conductor delimits a plurality of surrounded areas, wherein the areas are at least partly overlapping. Further, the encoder member is made of a conductive material so that it influences the magnetic field of the sender member as an Eddy current is induced in the encoder member. In other words, the magnetic field generated by the sender member is disturbed depending on the angular position of the encoder member. Thus, the rotational position of the encoder member can be determined.

US 2012/293166 A1 describes a rotary position sensor having a transmitter coil excited by a high frequency signal source. A first and second receiver coil, each having at least two oppositely wound loops, are rotatably positioned electrically degrees relative to each other.

US 2008/164869 A1 describes an inductive angular-position sensor, including a partially metallized disk that moves in rotation around its axis of revolution; and a stator that includes a primary coil and several secondary coils, whereby the secondary coils are arranged essentially symmetrically in pairs relative to the axis of revolution, so as to form one or more pairs of secondary coils, whereby the secondary coils of each pair are connected, on the one hand, to one another, in series and in phase opposition relative to one another, and, on the other hand, to the terminals of a measuring element that can generate an output signal that depends on the voltage at the terminals of the pair.

DE102017222575 A1 describes a sensor system for determining at least one rotational property of an element rotating about at least one axis of rotation A.

US 2019/056244 A1 describes embodiments that are directed to an inductive rotational position sensor that includes a sensor module having transmitting and receiving coils formed on a printed circuit board with a signal processor located in a center area enclosed by the transmitting and receiving coils.

WO 2017/100515 A1 describes a torque sensor for a steering mechanism having an input shaft joined to an output shaft by a torsion bar.

A disadvantage of the prior art sensor devices is that they are often imprecise. For example, a sensor device arranged in annular ring segment causes harmonics in the angular error, because the magnetic flux is different at the ends of the sensor relative to a central part of the sensor.

The object of the invention is thus to provide an alternative solution to existing sensor devices or sensor assemblies. A further object is to provide a solution that is optimized in assembly space, in particular reducing the area of the annular ring segment. A further object is to provide a solution that gives a higher precision.

This object is solved by the independent claim. Advantageous embodiments are solved by the dependent claims.

According to an embodiment, the sensor device is arranged at a stator for measuring the rotational position of an encoder member arranged at a rotor. The encoder member is rotatable about an axis of rotation. Herein a polar coordinate system is used in which each point on a plane is determined by a distance from a pole, namely the axis of rotation. The distance from the pole is measured in the radial direction and the angle is measured in the circumferential direction about the pole.

The sensor device comprises a sender member for emitting a magnetic field. The sender member is arranged at the stator. The sender member can comprise a coil in order to generate the magnetic field. In order to save space, the coil can be planar. In particular, the coil can be a spiral coil.

Furthermore, according to the embodiment, the sensor device comprises a receiving member for receiving the magnetic field, the receiving member comprising four adjacent sensor areas arranged along a circumferential direction C about the axis of rotation in a plane opposing the encoder member.

As used herein, adjacent means that the four areas are arranged side by side. The individual areas do not overlap. Advantageously, the individual areas are spaced apart from each other by a predetermined nonzero distance.

As further defined, the four areas are arranged along a circumferential direction. Thus, each area has substantially the same distance to the axis of rotation, but each area has a different angular component. In other words, the four areas are arranged within one annular ring.

Such a configuration enables to determine the rotational position by measuring only a voltage. In particular, the voltage needs to be amplified and rectified only, which can be done analog, and makes it easier to achieve a higher functional safety level.

Such a configuration further enables an alternative sensor device for measuring the rotational position of an encoder member arranged at the rotor, which is easy to fabricate. In particular, the four adjacent sensor areas can be particularly easy realized, e.g. as a printed circuit board.

Additionally or alternatively, according to one aspect, the sensor areas are arranged within an annular ring segment having period P along the circumferential direction C about the axis of rotation.

Herein, an annular ring segment is an angular sector of an annular ring, which is "cut off" from the rest of the annular ring. More specifically, an outer radius and an inner radius relative to the axis of rotation border the annular ring, wherein the outer radius is larger than the inner radius. Additionally, the segment is defined only in an angle Θ on the annular ring, wherein the angle Θ is smaller than the full mechanical resolution of 360° of the sensor.

In more detail, the sensor areas are arranged within an angle Θ around the circumferential direction about the pole. Mechanically, this annular ring segment has the nonzero length of the constant P that defines the fundamental period. Electrically, the period P corresponds to 2 Pi or 360 degrees. Herein, the term angular resolution refers to the electrical resolution.

According to this aspect, a plurality of n abutting annular ring segments, wherein n is an integer greater than 1, form mechanically a complete annular ring. Notably, a plurality of n elements on the rotor alternatively allow a full mechanical resolution. Such an annular ring segment enables to save costs and assembly space. Advantageously, a plurality of n encoder elements with period P are defined on the rotor, n being an integer inverse proportional to Θ.

Additionally or alternatively, each of the sensor areas is an annular ring segment in shape. Such a configuration allows the sensing area of the receiving member to be maximized with respect to the rotationally symmetrical geometry.

Additionally or alternatively, all sensor areas have substantially the same shape. Such a configuration allows that the periodic signal provided by each sensor area has the same amplitude. Notably, the signals are periodic with respect to the rotationally symmetrical geometry.

Additionally or alternatively, a first pair of sensor areas forms a first sensing element for providing a first sensing signal and a second pair of sensor areas forms a second sensing element for providing a second sensing signal. Two distinct signals enable an absolute angle measurement within the annular ring segment. I.e. by a comparison of the two distinct signals, e.g. a division operation, the absolute position within the ring segment can be determined. Such a configuration is particularly advantageous in case that the sensor areas are arranged within an annular ring segment having period P.

Additionally or alternatively, each sensor area is delimited by a conductor loop. In more detail, as used herein a loop is a turn of a wire. Thus, when magnetic field lines passes through the loop, the four sensing areas, each delimited by a conductor, sense the magnetic field generated by the sender member. Such a configuration allows an easy and economic fabrication of the sensor areas.

The term delimit can here be understood as circumscribe, surround and/or substantially enclose. The conductors do not have to be entirely closed around the surrounded areas. They can have small gaps for example in a contact section in which the conductors can be contacted. According to an advantageous embodiment, a first conductor forms a pair of first loops and a second conductor forms a pair of second loops. Such a configuration allows an economic fabrication of the first sensing element and the second sensing element.

According to an even more advantageous embodiment, each of the first loops formed by the first conductor is wound in opposite direction. Thus, in the first loops delimiting the first pair of sensor areas a voltage having an opposite sign is induced in each of the first loop. In other words, the pair of first loops wound in opposite direction allows a phase /anti-phase arrangement of the loops. Such a configuration allows a balanced coil system. Each receiver pair has a net zero voltage optimal case. By disturbing the balanced system with the rotor leads to a voltage in the receivers. Similarly, each of the second loops formed by the second conductor is wound in opposite direction.

According to an even more advantageous embodiment, the first loops and the second loops are arranged alternatively. In other words, the first loops are abutting to the second loops and vice versa.

Additionally or alternatively, the sender member can comprise a coil in order to generate the magnetic field. In order to save space, the coil can be planar. In particular, the coil can be a spiral coil.

In a space-saving configuration, the sender member surrounds the receiving members. Alternatively, the sender member comprises four coils each surrounding one receiving area. Preferably, abutting coils of the four coils are wound in opposite direction.

To keep the sensor device compact, the sender member lies substantially in the plane opposing the encoder member. The plane can be perpendicular to the axis of rotation. Such a plane has to be understood as a substantially flat object where one dimension is much smaller than the other two dimensions. Parts of the sensor device can for example be located on a front side of a PCB and other parts can be located on a backside of the PCB. In such an embodiment, the sensor device would still lie substantially in a plane.

In an easy-to-manufacture embodiment, the sender member and the receiving member can comprise a conductive path on a PCB. The conductive paths can comprise or be the conductors.

The magnetic field can be an alternating magnetic field. This can for example be achieved by applying an alternating current at the sender member.

According to an aspect, a sensor system comprises the sensor device described above and an encoder member, wherein the encoder member comprises an electrically conductive material. Such a configuration allows modifying parameters of the sender member, the receiving member, and the encoder member to optimize the electrical resolution and achieve lowest angular resolution errors. Parameters may be the width of the members in the radial direction and the height of the members in the circumferential direction.

Advantageously, the encoder member comprises a structure periodically changing with a period P along a circumferential direction C about the axis of rotation. Such a configuration allows that the output signal provided by the sensor areas is a periodically changing signal, from which the angular position may be detected.

Even more advantageously, the structure is based on a trigonometric function in shape. For example, the structure may be composed of a plurality of trigonometric functions. Composed means that for example a plurality of different trigonometric functions are combined by a mathematical operation. Such a configuration allows a highly efficient evaluation or calculation of the position of the encoder element. Generally, other configuration may be used which enable an unambiguous relationship between the change of the signal caused by the change area of encoder element opposing the sensor area.

Even more advantageously, the structure covers a half of the period P in circumferential direction C. In particular, the structure may be composed of four parts. Each part is adapted to cover one of the four receiving members. Such a configuration allows modifying the structure of the part of the encoder element to compensate for specific errors. Specific errors may be, e.g. errors which are be caused by edge effects of the magnetic field generated by the sender member.

Additionally or alternatively, the structure periodically changing with a period P along a circumferential direction C about the axis of rotation is mirror symmetrical with respect to an axis defined in a radial direction. Such a configuration allows receiving two distinct signals, which have a relationship. For example, in case that the first pair of sensor areas forms a first sensing element and the second pair of sensor areas forms the second sensing element, the first sensing signal has a periodic relationship with the second sensing signal.

In a further advantageous embodiment, the sections of each of the conductors that define the loops comprise mainly or only curved sections in the circumferential direction and only or mainly straight sections in the radial direction. This can further improve the signal quality as the sensor area is maximized. Notably, additional straight sections can however be present in other parts of the conductors. For example, parts of the conductors that do not surround the areas, e.g. connect the loop, and/or do not bound/limit the sensor areas, e.g. contacting sections and or a terminal or solder part.

In a further advantageous embodiment, a plurality of encoder structures are arranged on the rotor. In particular, each encoder structure has substantially the same shape. Such a configuration allows improving the accuracy.

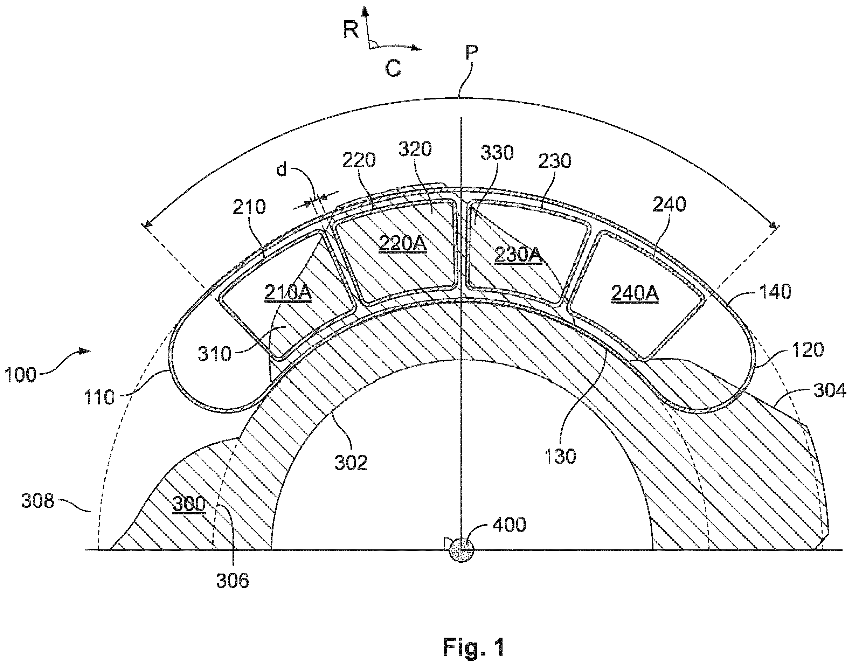

The invention will now be described in detail, in an exemplary manner using advantageous embodiments, and with reference to Fig. 1. The described embodiments are only possible configurations in which, however, the individual features as described above can be provided independently of one another or can be omitted.

FIG. 1 is a schematic view of a sensor system according to one embodiment.

In particular, the assembly comprises a sensor device for measuring the rotational position of an encoder element 300 that is rotatable about an axis of rotation 400. The sensor device comprises a sender member 100 for emitting a magnetic field and a receiving member for receiving the magnetic field.

The sender member 100 follows the shape of an annular ring segment. In particular, the sender member 100 comprises radial sections 110 and 120 and segment sections 130 and 140. The radial sections 110, 120 interconnect the opposing segment sections 130, 140 thereby forming a closed loop.

As a matter of presentation, in the figure the conductors are closed, but in fact at one side a loop is open and connected to an electronic circuitry such as an integrated chip that is measuring those signals. Furthermore, the closed loop can be spiral coil.

The sender member 100 comprises a conductive path that forms a coil, in particular a spiral coil on the arcuate carrier, which is embodied as a PCB. When running a current through the sender member, a magnetic field results which is then disturbed by the encoder member 300 and received by the receiving member. Depending on whether the current of the sender member runs in one direction or the other, for example clockwise or counterclockwise in the sender member 100, the magnetic field is directed in one direction or the other.

In general, the sender member 100 is in shape an annular ring segment. Thus, the sensor device can be fabricated in a particular compact design.

As further indicated in Fig. 1, the radial sections 110, 120 are formed as curved sections. However, the radial sections 110, 120 can be alternatively formed as straight sections. Curved sections may provide a more homogeneous magnetic field at the receiving element. Straight sections may enable a more compact design of the sensor device.

The receiving member according to the embodiment shown in Fig. 1 consists of four adjacent sensor areas 210A, 220A, 230A, and 240A. Alternatively, according to a not shown embodiment, the receiving member may comprise more than four adjacent sensor areas. For example, the sensor may consist of j time's 4 sensor areas j being an integer greater than 1.

According to the example shown in Fig. 1, conductors 210, 220, 230, and 240 delimit the sensor areas 210A, 220A, 230A, and 240A, respectively. Each conductor 210, 220, 230, 240 defines a closed loop. As a matter of presentation, in the figure the conductors 210, 220, 230, and 240 are closed, but in fact at one side each loop is open and connected to an electronic circuitry that is evaluating those signals.

According to an alternative embodiment, the closed loops surrounding the sensor areas are connected with traces on a printed circuit board (PCB).

According to an advantageous embodiment, not shown in Fig. 1, conductor 210 is connected to conductor 230 and conductor 220is connected to conductor 240.

According to the example disclosed in Fig. 1, the sensor areas 210A, 220A, 230A, and 240A are each shaped as an annular ring segment. In particular, each sensor area is delimited in radial direction by segment sections having substantially the same shape as the segment sections 130, 140 of the sender element 100. Substantially the same shape means that the section sections are parallel in polar coordinates. Such a configuration allows maximizing the area covered by the sensor areas within the annular ring surrounded by the sender member 100. The shape of an annular ring segment can be approximated as the shape of trapezoid.

According to the example disclosed in Fig. 1, the sensor areas 210A, 220A, 230A, and 240A are arranged adjacent in the circumferential direction C around the axis of rotation. In particular, abutting sensor areas 210A, 220A, 230A, and 240A are spaced apart by the distance d in the circumferential direction C. Such a configuration of not overlapping sensor areas enable an alternative solution to the rotary sensors with intersecting loops.

According to the example disclosed in Fig. 1, four sensor areas 210A, 220A, 230A, and 240A areas are arranged within an annular ring segment having period P along the circumferential direction (C) about the axis of rotation. Furthermore, all of the sensor areas have the same or identical shape. I.e., sensor areas 210A, 220A, 230A, and 240A are congruent when shifted along the circumferential direction.

Furthermore, according to the example disclosed in Fig. 1, each of the four sensor areas 210A, 220A, 230A, and 240A is arranged within an annular ring segment having a quarter of the period

P. Having a period P means that the annular ring segment has substantially the period P along a circumferential direction. In particular, a period P that deviates only by ΔP is intended to be seen as an annular ring segment having substantially the period P. In particular, ΔP is less than half the period P.

Not shown in the Figures is that the shape of only a part of the areas 210A, 220A, 230A, and 240A may deviate by use of a correction term. Such a configuration enables to correct for edge effects.

The encoder member 300 according to the embodiment shown in Fig. 1 is attached to the axis of rotation 400 such that it rotates with the axis of rotation 400. In this example, four flaps (Fig. 1 shows one flap completely and two flaps partly) are connected to a ring section and protrude sideways away from the ring section perpendicular to the axis of rotation 400. An inner radius 302 a ring radius 306, indicated by the dashed line, border the ring section of the encoder element 300. The flaps are arranged between the ring radius 306 and an outer encoder radius 308, indicated by a dashed line.

In more detail, the encoder element 300 is arranged between the inner radius 302 and an outer shape 304. The encoder element comprises a conductive element in the structure arranged between the outer shape 304 and the outer ring radius 306. For example, the conductive element is a metal or a conductive carrier like copper on the PCB or a conductive ink on a plastic disk.

As a matter of presentation, in the figure outer ring radius 306 is the diameter of the inner segment section 130 and the diameter from where the outer shape 304 starts..Similarly, outer encoder radius 308 is the diameter of the outer segment section 140 and the diameter that radially delimits the outer shape 304. According to an advantageous embodiment, the shape 304 starts at a diameter less than the outer ring radius 306, and ends at a diameter larger that the outer encoder radius 308.The encoder element consists of n segments, n being an integer inverse proportional to the period P. In particular, in Fig. 1 three of the four segments are at least partly shown.

Each segment consists of m adjacent parts, m being an integer proportional to number of sensor areas. In the arrangement shown in Fig. 1, each flap is formed by a first part 310 opposing the sensor area 210A, a second part 320 opposing the sensor area 220A, and a third part 330 opposing the sensor area 230A. A fourth part is defined by the void opposing sensor area 240A. In other words, the fourth part is defined where the ring radius 306 is equal to the outer shape 304 of the encoder element.

The encoder member 300 forms partly the first part 310, wherein the outer shape 304 of the encoder is changing in the circumferential direction, namely increasing in a clockwise direction, from the ring radius 306 to the outer radius 308. In particular, the outer shape 304 limiting the first part is curved. For example, as shown in Fig. 1, the shape follows a function that is based on a composition of trigonometric functions. Consequently, the effects from the Eddy current induced in the first part 310 can be optimized with respect to the arrangement of the sender member 100 and the receiving member.

Further, the encoder member 300 forms partly the second part 320, wherein the outer shape 304 of the encoder is constant in the circumferential direction following substantially the outer radius 308. In particular, the outer shape 304 is larger than the outer radius of segment sections of the sensor areas 210A, 220A, 230A, and 240A. Consequently, the effects from the Eddy current induced in second part 320 is maximized.

Further, the encoder member 300 forms partly the third part 330, wherein the outer shape 304 of the encoder is changing in the circumferential direction, namely decreasing in a clockwise direction, from the outer radius 308 to the ring radius 306. In particular, the outer shape 304 limiting the third part is curved. For example, as shown in Fig. 1, the shape follows a trigonometric function. Consequently, the effect from the Eddy current induced in the third part 330 can be optimized with respect to the arrangement of the sender member 100 and the receiving member.

Advantageously, the third part 330 is mirror symmetric to the first part 310 with respect to a symmetry axis that is directed in the radial direction R, wherein the symmetry axis passing through the center of the second part 320. Consequently, the same effect from the Eddy current is generated in the first part and the third part for the position shown in the figure.

Finally, the encoder member 300 comprises the void, wherein the outer shape 304 of the encoder is constant in the circumferential direction following substantially the ring radius 302. In particular, the outer shape 304 is less in radius than the inner radius of the segment sections of the sensor areas 210A, 220A, 230A, and 240A. Consequently, no effect from Eddy current is induced in a part of the encoder member forming the void.

Now, with reference to Fig. 1, a way of operating the sensor assembly is described. In the configuration shown in Fig. 1, four voltage values are sensed by the adjacent sensor areas. In particular, the voltage V4 is sensed by sensing area 240A. V4 is a maximum value of the voltage sensed by sensing area 240A as no Eddy current is induced in the void. Further, the voltage V2 is sensed by sensing area 220A. V2 is a minimum value of the voltage sensed by sensing area 220A as a maximum Eddy current is induced in the second part 320. Further, the voltage V1 is sensed by sensing area 210A. V1 is an intermediate value of the voltage sensed by sensing area 210A as an intermediate Eddy current is induced in the first part 310. Intermediate means a value between the maximum value and a minimum value. Finally, the voltage V3 is sensed by sensing area 230A. V3 is an intermediate value of the voltage sensed by sensing area 230A as an intermediate Eddy current is induced in the third part 310. By using the four voltage values V1 to V4, an absolute position of the encoder element 300 can be determined.

By rotating the encoder member all four voltage values are changing, and thus, a position dependent signal is generated.

Ideally, in the configuration shown in Fig. 1, the amount of the voltage value V1 equals the amount of voltage value V3, due to the symmetry of the arrangement. However, edge effects, e.g. by radial section 110, may cause errors so that the angular resolution deteriorates.

According to an advantageous embodiment, the sensing areas 210A and 230A are interconnected forming a first receiver and the sensing areas 220A and 240A are interconnected forming a second receiver. Such a configuration allows forming two balanced coil system. In particular, by disturbing the balanced system (with the rotor) leads to voltages in the two receivers.

For example, a sine signal is received from the first receiver and a cosine signal is received from the second receiver.

The configuration shown in Fig. 1 allows modifying the outer shape 304 of the first part 310 and the third part 330. In particular, the shape is curved to compensate for the edge effects. In other words, the geometry of the encoder element is modified to reduce angular errors.

Further, the configuration shown in Fig. 1 additionally allows modifying the width and height of the sender member 100 to compensate for edge effects. Further, the configuration shown in Fig. 1 additionally allows modifying the position of the sensor areas 210A, 220A, 230A, and 240A to compensate for edge effects. Such a configuration increases the flexibility for optimizing the arrangement in order to reduce edge effects.

**REFERENCE NUMERALS**

| **Reference Numeral** | **Description** |
|---|---|
| 100 | Sender member |
| 110, 120 | Radial sections |
| 130, 140 | Segment sections |
| 210A, 220A, 230A, 240A | Sensor areas |
| 210, 220, 230, 240 | conductors |
| 300 | Encoder member |
| 302 | Inner radius |
| 304 | outer shape |
| 306 | ring radius |
| 308 | Outer radius |
| 310 | First part |
| 320 | Second part |
| 330 | Third part |
| 400 | Axis of rotation |
| C | circumferential direction |
| R | radial direction |
| d | distance |
| P | period |
| P/2 | Half the period |
| P/4 | Quarter of the period |

## Claims

1. Sensor device arranged at a stator for measuring the rotational position of an encoder member (300) arranged at a rotor, the encoder member is rotatable about an axis of rotation (310), the sensor device comprising:
a sender member (100) arranged at the stator for emitting a magnetic field, wherein the sender member follows the shape of an outer annular ring segment, and
a receiving member for receiving the magnetic field,
**characterized in that**:
the receiving member comprising four adjacent not overlapping sensor areas (210A, 220A, 230A, 240A) arranged along a circumferential direction (C) about the axis of rotation (310) in a plane opposing the encoder member.

2. Sensor device according to claim 1, wherein the sensor areas (210A, 220A, 230A, 240A) are arranged within an annular ring segment having period P along the circumferential direction (C) about the axis of rotation.

3. Sensor device according to claim 1 or 2, wherein each of sensor areas is an annular ring segment in shape.

4. Sensor device according to any of claims 1 to 3, wherein all sensor areas have the same shape.

5. Sensor device according to any of claims 1 to 4, wherein a first pair of sensor areas forms a first sensing element for providing a first sensing signal and a second pair of sensor areas forms a second sensing element for providing a second sensing signal.

6. Sensor device according to any of claims 1 to 5, wherein each sensor area is delimited by a conductor loop (210, 220, 230, 240).

7. Sensor device according to any of claims 1 to 6, wherein the sender member comprises a coil.

8. Sensor device according to any of claims 1 to 7, wherein the sender member surrounds the sensor areas.

9. Sensor device according to any of claims 1 to 8, wherein the sender member lies in the plane opposing the encoder member.

10. Sensor device according to any of claims 1 to 9, wherein the sender member and/or the receiving member comprises a conductive path on a PCB.

11. Sensor system comprising a sensor device according to any of claims 1 to 10 and an encoder member, wherein the encoder member comprises an electrically conductive material.

12. Sensor system according to claim 11, wherein the encoder member comprises a structure periodically changing with a period P along a circumferential direction C about the axis of rotation.

13. Sensor system according to claim 12, wherein a part (310, 330) of the structure is based on a trigonometric function in shape.

14. Sensor system according to claim 13, wherein the part of the structure covers a quarter of the period P in the circumferential direction (C).

15. Sensor system according to any of claims 12 to 14, wherein the structure of the encoder member is mirror symmetrical with respect to an axis defined in a radial direction (R).

## Patentansprüche

1. Sensorvorrichtung, die an einem Stator angebracht ist, zur Messung der Drehlage eines an einem Rotor angeordneten Geberelementes (300), wobei das Geberelement um eine Drehachse (310) drehbar ist, wobei die Sensorvorrichtung umfasst:
ein am Stator angeordnetes Sendeelement (100) zum Aussenden eines Magnetfeldes, wobei das Sendeelement der Form eines äußeren Ringsegments folgt, und
ein Empfangselement zum Empfangen des Magnetfeldes,
**dadurch gekennzeichnet, dass**:
das Empfangselement vier benachbarte, sich nicht überlappende Sensorbereiche (210A, 220A, 230A, 240A) aufweist, die entlang einer Umfangsrichtung (C) um die Drehachse (310) in einer dem Geberelement gegenüberliegenden Ebene angeordnet sind.

2. Sensorvorrichtung nach Anspruch 1, wobei die Sensorbereiche (210A, 220A, 230A, 240A) innerhalb eines ringförmigen Ringsegments mit der Periode P entlang der Umfangsrichtung (C) um die Drehachse angeordnet sind.

3. Sensorvorrichtung nach Anspruch 1 oder 2, wobei jeder der Sensorbereiche die Form eines Ringsegments hat.

4. Sensorvorrichtung nach einem der Ansprüche 1 bis 3, wobei alle Sensorbereiche die gleiche Form aufweisen.

5. Sensorvorrichtung nach einem der Ansprüche 1 bis 4, wobei ein erstes Paar von Sensorbereichen ein erstes Sensorelement zur Bereitstellung eines ersten Sensorsignals bildet und ein zweites Paar von Sensorbereichen ein zweites Sensorelement zur Bereitstellung eines zweiten Sensorsignals bildet.

6. Sensorvorrichtung nach einem der Ansprüche 1 bis 5, wobei jeder Sensorbereich durch eine Leiterschleife (210, 220, 230, 240) begrenzt ist.

7. Sensorvorrichtung nach einem der Ansprüche 1 bis 6, wobei das Sendeelement eine Spule umfasst.

8. Sensorvorrichtung nach einem der Ansprüche 1 bis 7, wobei das Sendeelement die Sensorbereiche umgibt.

9. Sensorvorrichtung nach einem der Ansprüche 1 bis 8, wobei das Sendeelement in der dem Geberelement gegenüberliegenden Ebene liegt.

10. Sensorvorrichtung nach einem der Ansprüche 1 bis 9, wobei das Sendeelement und/oder das Empfangselement eine Leiterbahn auf einer Leiterplatte aufweist.

11. Sensorsystem mit einer Sensorvorrichtung nach einem der Ansprüche 1 bis 10 und einem Kodierelement, wobei das Kodierelement ein elektrisch leitfähiges Material umfasst.

12. Sensorsystem nach Anspruch 11, wobei das Kodierelement eine Struktur aufweist, die sich periodisch mit einer Periode P entlang einer Umfangsrichtung C um die Drehachse ändert.

13. Sensorsystem nach Anspruch 12, wobei ein Teil (310, 330) der Struktur auf einer trigonometrischen Funktion in Form basiert.

14. Sensorsystem nach Anspruch 13, wobei der Teil der Struktur ein Viertel der Periode P in der Umfangsrichtung (C) abdeckt.

15. Sensorsystem nach einem der Ansprüche 12 bis 14, wobei die Struktur des Geberelements spiegelsymmetrisch in Bezug auf eine in radialer Richtung (R) definierte Achse ist.

## Revendications

1. Dispositif de capteur disposé au niveau d'un stator permettant de mesurer la position en rotation d'un élément codeur (300) disposé au niveau d'un rotor, l'élément codeur pouvant tourner autour d'un axe de rotation (310), le dispositif de capteur comprenant :
un élément émetteur (100) disposé au niveau du stator dans le but d'émettre un champ magnétique, l'élément émetteur empruntant la forme d'un segment de bague annulaire externe, et
un élément de réception destiné à recevoir le champ magnétique,
**caractérisé en ce que** :
l'élément de réception comprend quatre zones de détection adjacentes sans chevauchement (210A, 220A, 230A, 240A) disposées le long d'une direction circonférentielle (C) autour de l'axe de rotation (310) dans un plan situé en face de l'élément codeur.

2. Dispositif de capteur selon la revendication 1, dans lequel les zones de détection (210A, 220A, 230A, 240A) sont disposées à l'intérieur d'un segment de bague annulaire de période P le long de la direction circonférentielle (C) autour de l'axe de rotation.

3. Dispositif de capteur selon la revendication 1 ou la revendication 2, dans lequel chacune des zones de détection présente la forme d'un segment de bague annulaire.

4. Dispositif de capteur selon l'une quelconque des revendications 1 à 3, dans lequel toutes les zones de détection présentent la même forme.

5. Dispositif de capteur selon l'une quelconque des revendications 1 à 4, dans lequel une première paire de zones de détection forme un premier élément de détection destiné à fournir un premier signal de détection, et une seconde paire de zones de détection forme un second élément de détection destiné à fournir un second signal de détection.

6. Dispositif de capteur selon l'une quelconque des revendications 1 à 5, dans lequel chaque zone de détection est délimitée par une boucle conductrice (210, 220, 230, 240) .

7. Dispositif de capteur selon l'une quelconque des revendications 1 à 6, dans lequel l'élément émetteur comprend une bobine.

8. Dispositif de capteur selon l'une quelconque des revendications 1 à 7, dans lequel l'élément émetteur entoure les zones de détection.

9. Dispositif de capteur selon l'une quelconque des revendications 1 à 8, dans lequel l'élément émetteur réside dans le plan en face de l'élément codeur.

10. Dispositif de capteur selon l'une quelconque des revendications 1 à 9, dans lequel l'élément émetteur et/ou l'élément de réception comprend une ligne conductrice sur un circuit imprimé.

11. Système de détection comprenant un dispositif de capteur conforme à l'une quelconque des revendications 1 à 10 ainsi qu'un élément codeur, l'élément codeur comprenant un matériau électriquement conducteur.

12. Système de détection selon la revendication 11, dans lequel l'élément codeur comprend une structure qui change périodiquement avec une période P le long d'une direction circonférentielle C autour de l'axe de rotation.

13. Système de détection selon la revendication 12, dans lequel une partie (310, 330) de la structure est fondée sur une fonction de forme trigonométrique.

14. Système de détection selon la revendication 13, dans lequel la partie de la structure recouvre un quart de la période P dans la direction circonférentielle (C).

15. Système de détection selon l'une quelconque des revendications 12 à 14, dans lequel la structure de l'élément codeur présente une symétrie spéculaire par rapport à un axe défini dans une direction radiale (R).
